# EUROPEAN PATENT APPLICATION

(11) **EP 2 075 878 A2**
(43) Date of publication of application: **01.07.2009**
(21) Application number: 08172945.1
(22) Date of filing: 24.12.2008
(51) Int. Cl.: H01R 13/24, H01R 12/22

(54) **Contact and interposer**

(30) Priority: 27.12.2007 JP 2007337624
(71) Applicant: Tyco Electronics AMP K.K., Kawasaki-shi, Kanagawa 213-8535 (JP)
(72) Inventor: Sakamoto, Katsuhiko, Kawasaki Kanagawa 213-8535 (JP); Takemasa, Eiichiro, Kawasaki Kanagawa 213-8535 (JP)
(74) Representative: Johnstone, Douglas Ian

(57) **Abstract**

A contact (10) for an interposer (1) for electrically connecting an array of first contacts (40) with a further array of second contacts (31). The contact (10) is in the form of a resilient loop comprising a spring section (11) with contact projections (121, 122) at diametrically opposed locations on the spring section (11) and a waisted portion (111) between the contact projections (121, 122). The waisted portion (111) is resiliently retained in a penetration hole (21) in the housing. The contact projections (121, 122) and adjacent part of the spring section (11) project from parallel penetration hole intersecting slits (22) in opposed front and rear surfaces (20a, 20b) of the housing (20).

## Description

The present invention relates to contacts for coming into contact with things, such as a pattern of contacts of an electric circuit board and a pattern of semiconductor contact bumps or solder balls. The invention also relates to a so-called interposer in which such a contacts are mounted on an insulator.

In the past probing tests, that measure an electric characteristic of two or more semiconductor chips formed on a semiconductor wafer have been performed. In such a test, contacts come into contact with terminals or other things such as the semiconductor bumps arranged on the semiconductor chip or chips.

For this purpose, known contact examples include so-called electro conductive rubber contacts, so-called Pogo pin contacts, stamping spring contacts produced by a die cutting process, and ring spring contacts with the electroformed pipes. An interposer, in which such contacts are mounted on or in an insulator is used in such a probing test.

A contact, there for such an interposer may for instance be a contact wherein two independent loops, which are produced by a die cutting processing, are connected. An example of such a contact is disclosed in U.S. Patent No. 5573435. The contact proposed in U.S. Patent No. 5573435 has high elasticity, is of low resistance, low self-inductance, and has a low spring constant.

A further contact or connection body formed by an MEMS (Micro Electro Mechanical System) process is disclosed in Japanese Patent Publication TokuHyou 2006-514289. The contact has a first contact section, one end of which comes into contact with a semiconductor bump, a connection section that has a C-shape extending continuously from the other end, a support section that is connected with one end of connection section and has a convex shape, and a second contact section that is inserted into an electric circuit board and has an 0-shape extending continuously from one end of the support section. Micro-processing is possible for this contact, because it is formed by the MEMS process. In particular, it is possible to use micro-processing to processing the end of the first contact section that comes into contact with the semiconductor bump, which would be difficult to implement with die cutting.

There is a problem that a contact that consists of electro-conductive rubber is inferior from a durability point of view. Also, there is a problem that a contact that consists of a Pogo-pin and/or ring spring has inferior contact reliability. Moreover, there is a problem with contacts that consist of stamping springs in that it is difficult to implement a further miniaturization because there is a miniaturization limit in micro-processing. Moreover such contacts are not suited to high density mounting and a high-speed signal transmission.

According to the contact proposed by U.S. Patent No. 5573435, two loops are provided which are independent. The contact provides a relatively small amount of displacement and results in a high contact pressure on an interposer that the contact is mounted in. It is difficult to miniaturize the two independent loops although it is desirable to reduce the loop size in order to provide a large amount of displacement and provide low contact pressure. The two independent loops are connected and ends of the loop engage a center section of the contact. Electrical connection can be broken when the contact receives a lateral load. Moreover, there are problems in that the contact does not provide high density mounting or high-speed signal transmission because the contact is one produced by a die cutting processing.

A further interposer contact is disclosed in Japanese Patent Publication TokuHyou 2006-514289. Each contact is mounted on an insulator in the interposer and the amount of displacement depends only on a cantilever beam of a connecting section. It is necessary to increase the thickness of the contact for example to 100µm or more to obtain sufficient displacement and to obtain a prescribed contact spring load. However, to form a contact with a thickness of 100µm using the MEMS process, it may take about ten hours. Because the contacts become consumed as a consequence of use, regular exchange of the contacts is necessary. Increasing the thickness of such contacts increases the overall costs.

In view of the foregoing, it is an object of the present invention to provide a contact which has high durability, high contact reliability, is capable of a high density mounting on an insulator, and also can cope with high signal speeds.

To achieve the above-mentioned objects, the present invention provides a contact comprising: a spring section that is formed as a loop for being subjected to elastic deformation by squeezing; and a pair of contacts formed such that the contacts project outside the loop at positions separated from one another by about half a circumference of the loop of the spring section, each contact being arranged to contact an associated thing to be contacted.

According to the contact of the present invention, the spring section is subjected to elastic deformation by urging, and the contact has a pair of contacts that project outside the loop. Therefore, according to the contact of the present invention, when a pair of contacts come into contact with the things to be contacted, it is possible to obtain a highly concentrated contact stress even when contact load is low. That is a low touching pressure. Accordingly, even if the contamination or pollutants, for example an insulation film, are formed on the surfaces of the thing to be contacted, the contacts destroy these by the high concentrated stress, and thus it is possible to obtain an excellent (low) contact resistance. Moreover, the contact of the present invention is of a shape similar to a beam with both ends fixed. This is different from the shape of a conventional contact in which the amount of displacement depends only on a cantilever beam shaped connection section. Therefore, according to the contact of the present invention, it is possible to obtain an amount of displacement that is larger than that of a conventional contact without thickening the material of the contact. In addition, the contact of the present invention, includes a spring section that is formed as a loop (for example a no edge loop). This feature avoids the problem of the connection becoming detached as a result of receiving lateral loads. This differs from conventional contacts of the type described above wherein ends of two loops may be connected to a central contact section. Thus, it is possible to maintain the structure and the function of the contact. Therefore, according to the contact of the present invention, it is possible to provide a contact having high durability and high contact reliability.

Moreover, the contact of the present invention may be made very small and produced by micro process techniques that combine photolithography and electroforming, which are well known. This feature makes it possible to mount the contact on the insulator at a high mounting density. Moreover, the use of the very small contact makes it possible to conduct a high-speed signal because it has a short electrical length. Moreover, the application of the micro process technique that combines photolithography and electroforming makes it possible that the contact tips can be very sharply formed and have a radius of curvature of several µm only. Thus it is possible to obtain a higher concentrated stress even with a low contact pressure. Therefore, the contact of the present invention, provides high contact reliability.

According to the contact of the present invention, it is possible to produce a contact for instance one that consists of an Ni alloy such as Ni-Co and NiMn (for instance, Hv450-Hv600) with a micro process technique that combines photolithography and electroforming, which are well known. Contacts that consist of Ni alloys are strong and abrasion resistant, and have high durability.

In the contact according to the present invention as mentioned above, it is preferable that each tip of the pair of contacts is formed as a circular arc of radius 30µm or less. It should be noted that a radius of curvature of 50µm is a manufacturing minimum limit for a die cutting processing.

In the contact according to the present invention, as mentioned above, it is preferable that the contact has a thickness of 50µm or less, desirably 30µm or less. The reason why this is desirable is that undue time is required for the formation of a contact having a thickness that exceeds 50µm although it is possible to form one with electroforming in around one hour in case of one having a thickness of 50µm.

According to the contact of the present invention, as mentioned above, it is possible to obtain an amount of displacement that is larger than that of a conventional contact in which the amount of displacement depends only on a cantilever beam shaped connection section. Therefore, according to the contact of the present invention, there is no need to thicken the thickness of contact, for example to or above 100µm. Thus, according to the feature as mentioned above, the contact can be produced at low-cost.

In the contact according to the present invention as mentioned above, it is preferable that the spring section has a narrowed or waisted portion that is narrower that outer portions, mid-way between two positions at which the pair of contacts are arranged.

According to the contact having such a narrowed portion, the use of the narrowed portion makes it possible to mount the contact on the insulator at a higher density.

In the contact according to the present invention as mentioned above, it is preferable that the spring section is formed as a loop, and wherein spring section portions on the opposite sides of a straight line that connects the pair of contacts have different cross-sectional shapes.

According to the feature as mentioned above, both sides of the spring section are distorted and transformed when the pair of contacts come into contact with the things to be contacted. As a result, the pair of contacts moves in a transverse or horizontal direction when contacted so that wiping an action occurs. Thus, according to the feature as mentioned above, even if the contamination or pollutants e.g. an insulation film are formed on the surfaces of the things to be contacted, these are reliably removed by the wiping action of the pair of contacts, so that a low contact resistance is obtained. As a result, the contact has extremely high contact reliability.

The spring section is preferably formed so as to be non-symmetric in shape relative to the above mentioned straight line.

According to the feature as mentioned above, both sides of the spring section are distorted and transformed when the pair of contacts come into contact with the things to be contacted. As a result, the pair of contacts move in a transverse or horizontal direction, so that a wiping action is established.

To achieve the above-mentioned objects, the present invention provides a first interposer comprising: a contact as described above; and a housing that has a pair of plate members wherein slits are formed wherein each contact and an adjacent part of the spring section project from a respective slit.

According to the first interposer it is possible to provide an interposer having high durability, high contact reliability, is able to accommodate contacts mounted at a high density, and can cope with a high signal speeds.

To achieve the above-mentioned objects, the present invention also provides a second interposer comprising: a contact as described above and including contacts with the narrowed portions; and a housing that has a thickness in a direction between the pair of contacts, and has a board support body having a penetration hole which the narrow portions enter. This interposer provides the same advantages to that described above.

To achieve the above-mentioned objects, the present invention also provides a third interposer comprising a contact as described above and including the narrowed portion; and a housing that has thickness in a first direction that is larger than a dimension in the first direction of the narrowed portion and is smaller than a dimension between the pair of contacts, the housing having penetration holes and slits which penetrate the penetration holes respectively on opposed front and back surfaces of the housing and are parallel to the front and the back surfaces, wherein the narrowed portion of the contact is positioned in a central part of the penetration hole, and wherein each one of the pair of contacts and an adjacent portion of the spring section project from one of the slits in a respective one of the front and back surfaces of the housing, and the housing has a board support body.

The third interposer has the advantages of the first and second interposers. Moreover, according to the third interposer, the contacts have the narrowed portions, and thus the use of the narrowed portions makes it possible to mount the contacts on the housing at a higher density. Moreover, according to the third interposer, the position of the contact mounted on the housing is stabilized by the slit.

In the first interposer or the third interposer according to the present invention as mentioned above, it is preferable that the housing has a rectangular shape, and the slits are each a slit which extends diagonally with respect to a side of the rectangular shape of the housing.

The feature mentioned above makes it possible to mount the contact on the housing in a higher density.

The invention will now be described by way of example only with reference to the accompanying drawings in which:
FIG. 1 is a perspective view of an interposer according to a first embodiment of the present invention.
FIG. 2 shows three views of the interposer according to the first embodiment of the present invention.
FIG. 3 is a part cross-sectional view of the interposer according to the first embodiment of the present invention.
FIG. 4 is a part cross-sectional right side view of the interposer according to the first embodiment of the present invention.
FIG. 5 is an enlarged part cross-sectional view of a housing of an interposer according to a second embodiment of the present invention.
FIG. 6 is similar to FIG. 5 and shows a third embodiment of the present invention.
FIG. 7 is similar to FIG. 5 and shows a fourth embodiment of the present invention.
FIG. 8 is similar to FIG. 5 and shows a fifth embodiment of the present invention.
FIG. 9 is similar to FIG. 5 and shows a sixth embodiment of the present invention.
FIG. 10 is a plan view of an interposer according to a seventh embodiment of the present invention.

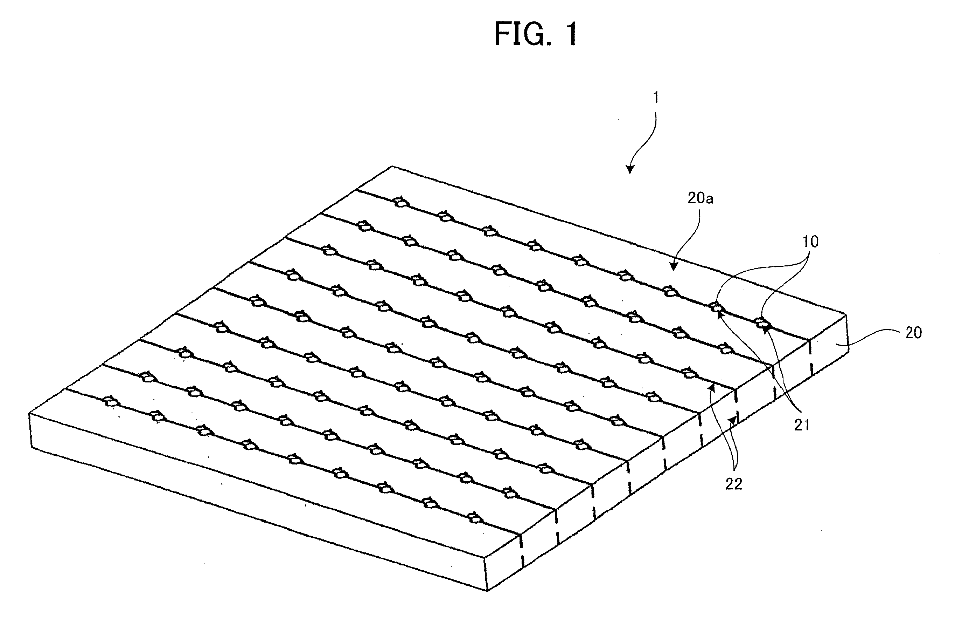

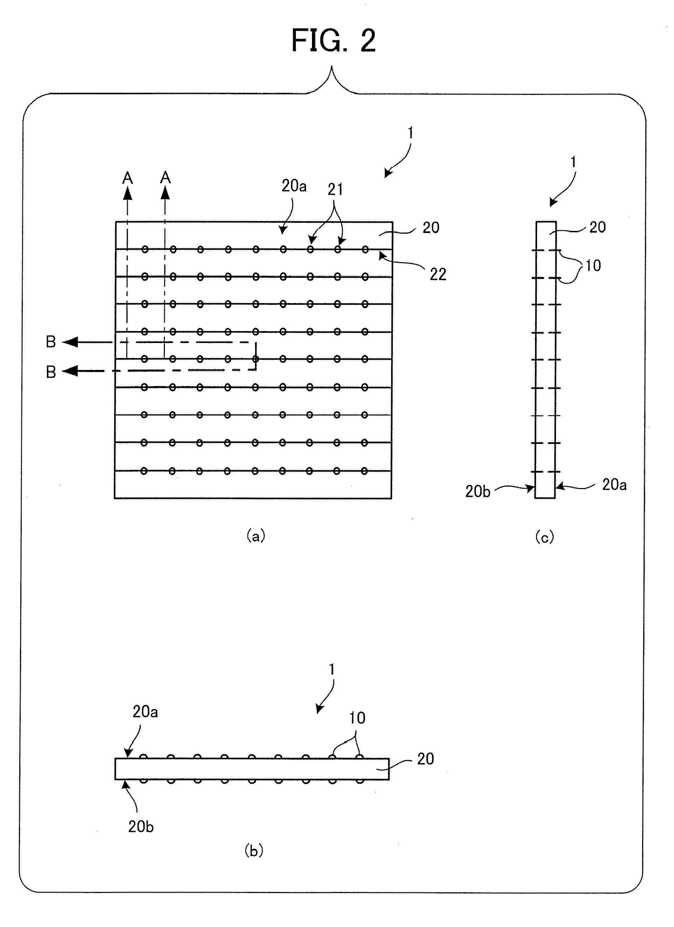

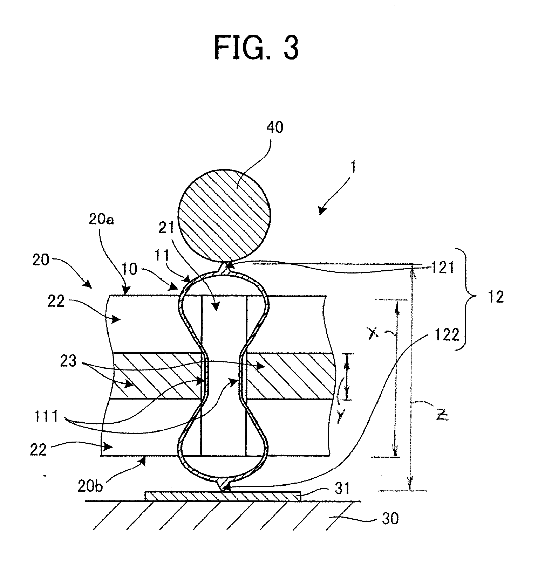

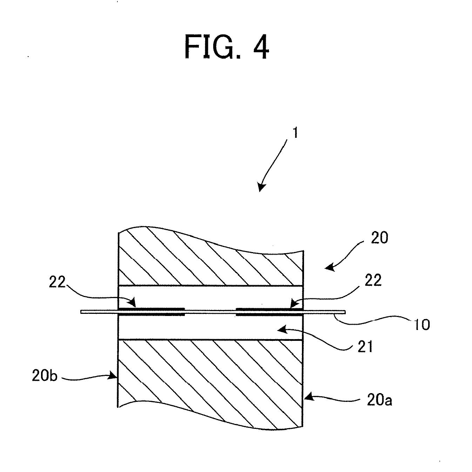

FIG. 1 is a perspective view of an interposer according to a first embodiment of the present invention. FIG. 2 is a plan view of the interposer according to the first embodiment of the present invention. Part (a) of FIG. 2 is a plan view. Part (b) of FIG. 2 is a front view. Part (c) of FIG. 2 is a right side view. FIG. 3 is an enlarged sectional view taken along the line A-A line of FIG. 2. FIG. 4 is an enlarged sectional view taken along the line B-B line of FIG. 2. For the sake of convenience of the explanation, FIG. 3 additionally shows a pad 31 of an electric circuit board 30 and a semiconductor bump 40.

An interposer 1 is composed of a contact 10 and a housing 20 of an insulator material to or in which one or more contacts 10 is mounted.

The contact 10 is provided with a spring section 11 and a pair 12 of contacts 121,122. The contact 10 corresponds to a first embodiment of a contact of the present invention. The contact 10 is for instance one that consists of the Ni alloy such as Ni-Co and NiMn (for instance, Hv450-Hv600), and is produced with a micro process technique that combines photolithography and electroforming, and which is well known. Therefore, the thickness of the contact 10 can be assumed to be a thickness of 50µm or less, and, for instance, it is assumed herein to be 20µm. The contact 10 that consists of the Ni alloy has light abrasion resistance and durability.

The spring section 11 of the contact 10 is in the form of a loop which is subjected to elastic deformation by squeezing or urging. Moreover, the spring section 11 is dumbbell or gourd-shaped having a narrowed or waisted portion 111 at an intermediate or middle portion between the pair of contacts 121,122.

The pair of contacts 121,122 of the contact 10 are formed at substantially diametrically opposed positions and on the outside of the loop of the spring 11. Moreover, each tip of the pair of contacts 121,122 is formed a micro process or process technique that combines photolithography and electroforming so as to have a circular arcuate form having a radius of curvature of 30µm or less, and, may for example have a radius of curvature of 5µm. The contacts 121,122 are urged to contact things such as a terminal eg a pad 31 of an electric circuit board 30 and a semiconductor bump or solder ball 40.

Therefore, with the contact 10 of the first embodiment, when each contact 121,122 comes into contact with the thing with which contact is to be made, it is possible to obtain a highly concentrated stress(or force per unit area) even when a low contact or touching pressure load is provided. Accordingly, even if contamination or pollutants, possibly in the form of an insulation film is formed on the surface of the contacted items exists, the contacts 121,122 destroy or remove the contamination as a result of the highly concentrated stress. Thus it is possible to obtain an excellent low contact resistance. Moreover, each spring section 11 of the first embodiment is of a shape which approximates to the beam, both ends which are fixed. This is different from the shape of a conventional contact in which the amount of displacement depends only on a cantilevered beam shaped connection section. Therefore, with the contact 10 of the first embodiment, it is possible to obtain an amount of contact displacement that is larger than that provided by a conventional contact without thickening the contact 10. The thickness of the contact 10 can accordingly be for example 20µm, and the contact 10 can thus be produced at a low-cost. In addition, according to the contact 10 of the first embodiment, the spring section 11 is in the form of a loop. The loop may possibly have no edge. This feature avoids the problem of the connection becoming ineffective or coming off as a result of receiving a lateral load. This is different from the conventional contact referred to above wherein ends of two loops are connected to a centre section of a contact center section. Thus, it is possible to maintain the structure and the function of the contact 10. Moreover, the contact 10 is formed with a micro process technique that combines photolithography and electroforming such that tips of the contacts 121,122 of the contact 10 are very sharply formed with a circular arc of a minute radius of 5µm for instance. Thus it is possible to obtain a highly concentrated stress or contact pressure even when a low overall contact pressure is provided. Therefore, according to the contact 10 of the first embodiment, it is possible to provide a contact having high durability and reliability.

Moreover, the contact 10 of the first embodiment is a very small one which can be produced with the micro process technique that combines photolithography and electroforming. This feature makes it possible to mount the contacts 10 on the housing 20 with a high density. Moreover, the use of the narrowed portions 111 makes it possible to mount the contacts 10 on the housing 20 at a high density. The use of the very small contact 10 makes it possible to conduct signals at high-speed because the electrical length is short.

The housing 20 has a thickness X that is greater than a thickness Y of the board support body 23 that supports the waisted portions 111 of the contacts and is less than a distance Z between the pair of contacts 121,122. The housing 20 has two or more circular penetration holes 21 and slits 22 each having a width somewhat greater than a thickness t of the contacts 10. The slits 22 each penetrate two or more of the penetration holes 21 on a front surface 20a and on a back surface 20b of the housing 20 respectively. These slits 22 are parallel to the front surface 20a and the back surface 20b. The waisted portion 111 of each contact 10 enters a central part of a respective penetration hole 21, and the front surface 20a and the back surface 20b are arranged such that the one contact 121, 122 and the adjacent spring section 11 projects from a respective associated slit 22 on each surface of the housing 20. The housing 20 has a board support body 23 that supports the mounted contacts 10.

Therefore, the interposer 1 of the first embodiment is highly durable, and reliable, is able to support contacts mounted at a high density, and is able to cope with and transmit high-speed signals. Moreover, in the interposer 1, the position of each contact mounted in the housing 20 is stabilized by the slits 22.

Next, there will be explained a second embodiment of the interposer of the present invention.

The second embodiment is one in which the contact 10 of the first embodiment is replaced with an alternative contact 50 which has a different shape from the contact 10.

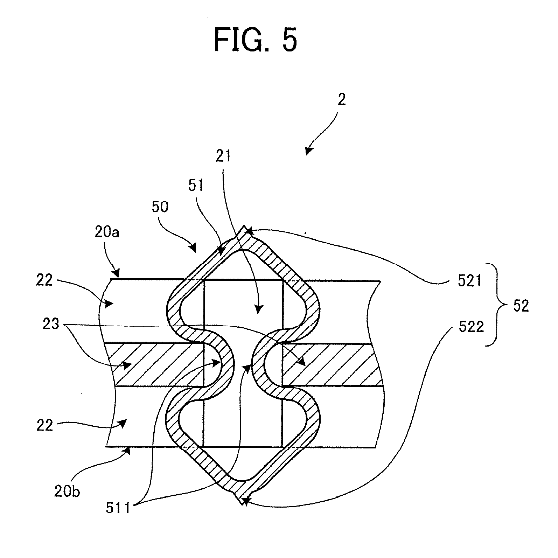

In FIGS. 5 to 7, the same parts as are shown in FIGS. 1 to 4 are denoted by the same reference numbers and explanation of these parts has been omitted. The following description of FIGS 5 to 7 explains only the differences from the first embodiment.

FIG. 5 is an enlarged sectional view of a portion of the housing 20 of the interposer 2 according to the second embodiment of the present invention in which the contact 50 is mounted.

The interposer 2 comprises the contacts 50 and the housing 20 of an insulator material in which the contacts 50 are mounted.

Each contact 50 has a spring section 51 and a pair 52 of contacts 521,522. The contact 50 corresponds to the second embodiment of a contact of the present invention.

The spring section 51 of the contact 50 is in the form of a loop which is subjected to elastic deformation by squeezing or urging. Moreover, the spring section 51 is substantially dumbell or gourd-shaped having a narrowed or waisted portion 511 at an intermediate or middle portion between the pair 52 of contacts 521, 522. Thus outer or upper and lower portions of the loop each have an arrowhead shape.

The pair 52 of contacts 521,522 of the contact 50 are formed in such a manner that the contacts 521 and 522 project on the outside of the spring section 51 at positions such that they are separated from one another by about half a circumference of the loop of the spring 51. They are accordingly substantially diametrically opposed. The pair 52 of contacts 521,522 are urged into contact with the associated items to be contacted.

The interposer 2, has high durability and high contact reliability. The contacts 50 can be mounted at a high density, and are able to cope with high-speed signals.

Next, there will be explained a third embodiment of the interposer of the present invention.

The following third embodiment is one in which the contact 10 of the first embodiment is replaced with an alternative contact 60 which has a different shape from the contact 10.

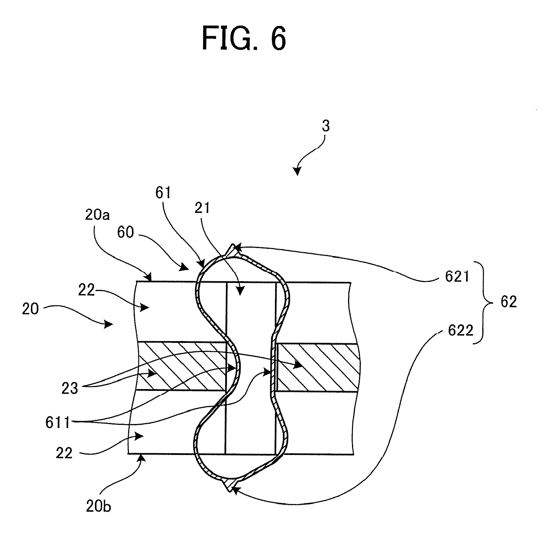

FIG. 6 is an enlarged sectional view of a portion of the housing 20 of an interposer 3 according to a third embodiment of the present invention in which the contact 60 is mounted.

The interposer 3 comprises the contacts 60 and the housing 20 of an insulator material in which the contacts 60 are mounted.

Each contact 60 has a spring section 61 and a pair 62 of contacts 621,622. The contact 60 corresponds to the third embodiment of a contact of the present invention.

The spring section 61 of the contact 60 is in the form of a loop which is subjected to elastic deformation by squeezing or urging. Moreover, the spring section 61 is substantially dumbbell or gourd-shaped having a narrowed or waisted portion 611 at an intermediate or middle portion between the pair 62 of contacts 621, 622. The loop shape of the spring section 61, has a non-symmetrical shape with respect to a straight line that connects the pair 62 of contacts 621,622.

The pair 62 of contacts 621,622 of the contact 60 are formed in such a manner that the contacts 621 and 622 project on the outside at positions of the contact 60 that are separated from one another by about half a circumference of the loop of the spring section 61. They are accordingly substantially diametrically opposed. The pair of contacts 621,622 comes in contact to the associated things to be contacted.

According to the interposer 3 of the third embodiment the loop shape of the spring section has a non-symmetrical shape and opposite sides of the spring section 61 are distorted and transformed when a pair 62 of contacts 621,622 thereof come into contact with the things to be contacted and are distorted thereby. As a result, the contacts 621,622 move in a transverse or horizontal direction so that a wiping action is established. Thus, according to the interposer 3 of the third embodiment, even if contamination or pollutants such as an insulation film is formed on the surface of the thing to be contacted, it is reliably removed by the wiping action of the contacts 621,622. Accordingly very low contact resistance can be achieved. As a result, extremely high contact reliability is achieved. In the interposer 3, high durability is achieved, and it is possible to mount the contacts at a high density, and cope with high-speed signals.

Next, there will be explained a fourth embodiment of the interposer of the present invention.

The fourth embodiment is one in which the contact 10 of the first embodiment is replaced with an alternative contact 70 which has a different shape from the contact 10.

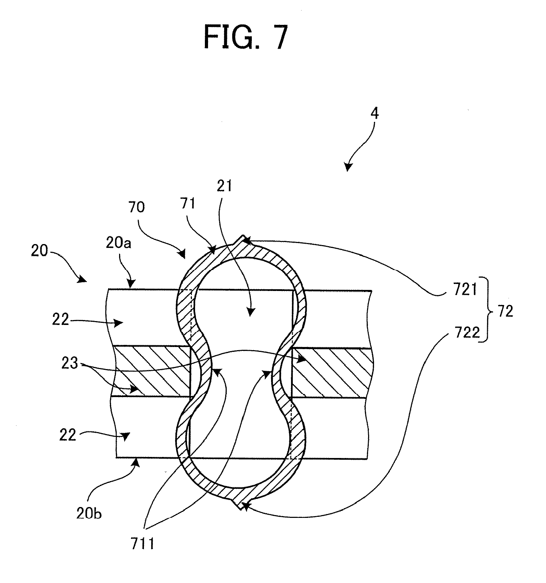

FIG. 7 is an enlarged sectional view of a portion of the housing 20 of the interposer 4 according to the fourth embodiment of the present invention in which the contact 70 is mounted.

The interposer 4 comprises the contacts 70 and the housing 20 of an insulator material in which the contact 70 are mounted.

Each contact 70 has a spring section 71 and a pair 72 of contacts 721,722. The contact 70 corresponds to the fourth embodiment of a contact of the present invention.

The spring section 71 of the contact 70 is in the form of a loop which is subjected to elastic deformation by squeezing or urging. Moreover, the spring section 71 is substantially dumbbell or gourd-shaped having a narrowed or waisted portion 711 at an intermediate or middle portion between the pair 72 of contacts 721, 722. The shapes of the spring section 71, on either side of a straight line that connects the pair of contacts 721,722 are different from each other.

The pair of contacts 721,722 of the contact 70 are formed in such a manner that the contacts 721 and 722 project on the outside at positions of the contact 70 that are separated from one another by about half of a circumference of the loop of the spring section 71. They are accordingly substantially diametrically opposed. The pair of contacts 721,722 are urged into contact with the associated items to be contacted.

In the interposer 4 of the fourth embodiment opposite sides of the spring section 71, on either side of a straight line connecting the pair of contacts 721,722 have different sectional shapes. Accordingly in a similar fashion to that of the interposer 3, both sides of the spring section 71 distort and transform when the contacts 721,722 come into contact with the items to be contacted. Consequently the contacts 721,722 move in the transverse or horizontal direction relative to the thing to be contacted, so that a wiping action occurs. Thus, even if contamination or pollutants possibly in the form of an insulation film are formed on the surface of the thing to be contacted, these are displaced by the wiping action of the contacts 721,722, so that low contact resistance is obtained. As a result, contact reliability is high. In the interposer 4, high durability is achieved, the contacts can be mounted at a high density, and the interposer is able to cope with high signal speeds.

Next, there will be explained a fifth embodiment of the interposer of the present invention.

The fifth embodiment is one in which the contact 10 and the housing 20, that are components of the interposer 1 of the first embodiment mentioned above are replaced respectively with a contact 80 and a housing 210 which are different in shape from those of the first embodiment.

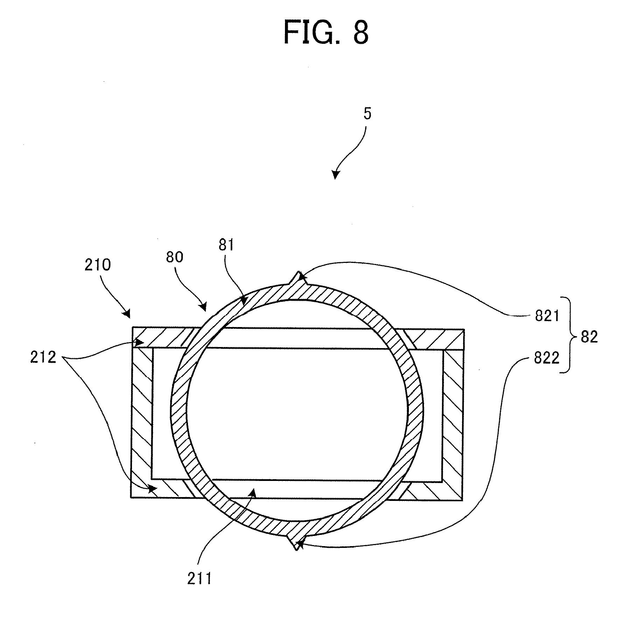

FIG. 8 is an enlarged sectional view of a portion of the interposer 5 in which contact 80 is mounted in the housing 210.

The interposer 5 comprises the contacts 80 and the housing 210 of an insulator material in which the contacts 80 are mounted.

Each contact 80 has a spring section 81 and a pair 82 of contacts 821,822. The contact 80 corresponds to the fifth embodiment of a contact of the present invention.

The spring section 81 of the contact 80 is in the form of a loop which is subjected to elastic deformation by squeezing or urging, and has a round form.

The contacts 821,822 are formed in such a manner that they project on the outside at positions separated from one another by about half a circumference of the loop of the spring section 81. They are accordingly substantially diametrically opposed. The contacts 821,822 come into contact with the associated things to be contacted.

The housing 210 has a thickness that is smaller than a distance between the contacts 821,822. The housing 210 has a pair of plate members 212 in which slits 211 are formed which permit the contacts to project, together with parts of the spring section 81 that are adjacent to the contacts. The interposer 5 has high durability, high in contact reliability, and enables the contacts to be mounted at a high density, and cope with a high signal speeds.

Next, there will be explained a sixth embodiment of the interposer of the present invention.

The sixth embodiment is one in which the contact 10 and the housing 20 of the first embodiment mentioned above are replaced with a contact 90 and a housing 220 which are different in shape from the contact 10 and the housing 20.

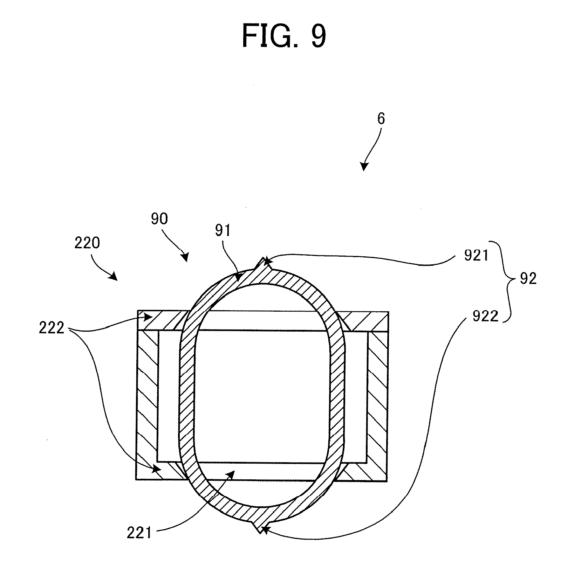

FIG. 9 is an enlarged sectional view of a portion of the interposer 6 in which a contact 90 is mounted in the housing 220 according to the sixth embodiment of the present invention.

The interposer 6 comprises contacts 90 and the housing 220 of an insulator material in which the contacts 90 are mounted.

Each contact 90 has a spring section 91 and a pair 92 of contacts 921,922. The contact 90 corresponds to the sixth embodiment of a contact of the present invention.

The spring section 91 of the contact 90 is in the form of a loop which is subjected to elastic deformation by squeezing or urging, and is substantially round or oval.

The contacts 921,922 of the contact 90 are formed in such a manner that the contacts 921 and 922 project on the outside at positions separated from one another by about half a circumference of the loop of the spring section 91. They are accordingly substantially diametrically opposed. The contacts 921,922 come into contact to the associated things to be contacted.

The housing 220 has thickness that is thinner than a distance between the contacts 921,922. The housing 220 has a pair of plate members 222 in which slits 221 are formed. These slits 221 allow the contacts to project together with parts of the spring section 91 that are adjacent to the contacts.

The interposer 6 has high durability, high contact reliability, and allows contact to be mounted at a high density, and be able to cope with a high signal speeds.

Next, there will be explained a seventh embodiment of the interposer of the present invention.

The seventh embodiment is one in which the housing 20 is replaced with a housing 220 which is different in shape from the housing 20.

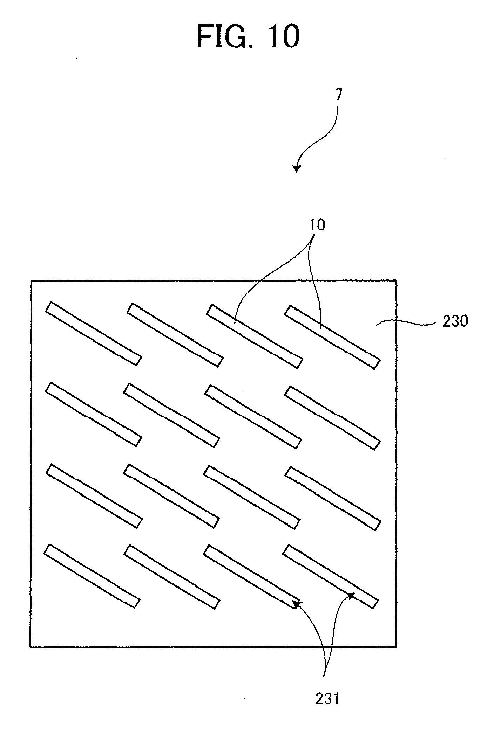

FIG. 10 is a plan view of the interposer 7 according to a seventh embodiment of the present invention.

The interposer 7 comprises contacts 10 (as described with reference to FIG. 3) and a housing 230 of an insulator material in which the contacts 10 are mounted.

As for the housing shown in FIG. 3 the housing 230 has thickness that is greater than a distance spanned by a pair of contacts 121,122 of the narrowed or waisted portions 111 of the contact 10 and is less than the distance between the contacts 121,122. The housing 230 has a rectangular parallelepiped shape. Two or more contacts 10 are arranged in a two-dimensional array. Slits 231 extended diagonally with respect to sides of the rectangular shape of the housing 230 as seen in plane view.

With the interposer 7, it is possible to mount the contacts 10 in the housing 230 with a higher density. Also the interposer 7 has high durability, is able to accommodate contacts mounted at a high density, and is able to cope with a high signal speeds.

As well as being used for the interposers described the contacts according to the embodiments described above can be used in a test socket of a semiconductor testing device and facilitate the connection to high density substrates.

Moreover, the interposer according to the embodiments as mentioned above can be applied to high density mounting for ultrasonic diagnostic equipment for the medical treatment such as CT, MRI, and NMR, as well as for devices for probe testing which measure electric characteristics, for instance.

Moreover, even though the interposers of the first to fourth embodiments are examples in which the housing has two or more penetration holes and slits, it would be acceptable for the housings referred to in the present invention to have a board support body that has a thickness corresponding to a thickness in a direction where a pair of contacts, of the narrowed or waisted portions of the contact exists, and where the housing has penetration holes which the narrow portions of the contacts enter.

As mentioned above, according to the present invention, each contact has high durability, high contact reliability, is able to be mounted at a high density, and is able to cope with a high signal speeds. The interposers employing the contacts have corresponding advantages.

While the present invention has been described with reference to the particular illustrative embodiments, it is not to be restricted by those embodiments but only by the appended claims. It is to be appreciated that those skilled in the art can change or modify the embodiments without departing from the scope of the present invention.

## Claims

1. A contact (10) comprising:
a spring section (11) that is formed as a loop for being subjected to elastic deformation by squeezing; and
a pair of contacts (121, 122) formed such that the contacts project outside the loop at positions separated from one another by about half a circumference of the loop of the spring section (11), each contact (121, 122) being arranged to contact an associated thing to be contacted.

2. The contact (10) according to claim 1, wherein a tip of each contact (121, 122) is formed to have radius of curvature of 30µm or less.

3. The contact (10) according to claim 1 or 2, wherein the contact (10) has a thickness of 50µm or less.

4. The contact (10) according to any preceding claim, wherein the spring section (11) has a narrowed portion (111), which is narrower than outer portions, mid-way between two positions at which the pair of contacts (121, 122) are arranged.

5. The contact (60) according to any preceding claim, wherein the spring section (61) is formed as a loop, and wherein spring section portions on opposite sides of a straight line that connects the pair of contacts (621, 622) have different cross-sectional shapes.

6. The contact (60) according to any preceding claim, wherein the spring section (61) is formed as a loop, and wherein the spring section (61) has a non-symmetrical shape relative to a straight line that connects the pair of contacts (621, 622).

7. An interposer (5) comprising:
a contact (80) according to any preceding claim; and
a housing (210) that has a pair of plate members (212) wherein slits (211) are formed wherein each contact (121, 122) and an adjacent part of the spring section (81) project from a respective slit (211).

8. An interposer (1) comprising:
a contact (10) according to claim 4; and
a housing (20) that has thickness (X) in a direction between the pair of contacts (121, 122), and has a board support body (23) having a penetration hole (21) in which the narrowed portion is positioned.

9. An interposer comprising:
a contact (10) according to claim 4; and
a housing (20) that has thickness (X) in a first direction that is larger than a dimension (Y) in the first direction of the narrowed portion and is smaller than a dimension (Z) between the pair of contacts (121, 122), the housing (20) having penetration holes (21) and slits (22) which penetrate the penetration holes (21) respectively on opposed front and back surfaces (20a, 20b) the housing (20) and are parallel to the front and the back surfaces, wherein the narrowed portion (111) of the contact (10) is positioned in a central part of the penetration hole (21), and wherein each one of the pair of contacts (121, 122) and an adjacent portion of the spring section (11) project from one of the slits of a pair of contacts are one of the slits (22) in a respective one of the front and back surfaces (20a, 20b) of the housing (20), and the housing (20) has a board support body (23).

10. The interposer according (5) to claim 7 or 9, wherein the housing (210) has a rectangular shape, and the slits (211) each extend diagonally with respect to a side of the rectangular shape of the housing (210).
